# EUROPÄISCHE PATENTSCHRIFT

(11) **EP 2 369 031 B1**
(45) Veröffentlichungstag und Bekanntmachung des Hinweises auf die Patenterteilung: **04.05.2016**
(21) Anmeldenummer: 10173410.1
(22) Anmeldetag: 19.08.2010
(51) Int. Cl.: C23C 14/08, C23C 14/32, H01J 37/32

(54) **BESCHICHTUNG AUF NIAL2O4 BASIS IN SPINELLSTRUKTUR**
COATING ON A NIAL2O4 BASIS IN SPINEL STRUCTURE
REVÊTEMENT À BASE DE NIAL2O4 DANS UNE STRUCTURE DE SPINELLE

(30) Priorität: 18.03.2010 US 315106 P
(43) Veröffentlichungstag der Anmeldung: 28.09.2011
(73) Patentinhaber: Oerlikon Trading AG, Trübbach, 9477 Trübbach (CH)
(72) Erfinder: Ramm, Jürgen, 7304 Maienfeld (CH)
(74) Vertreter: Naefe, Jan Robert

(56) Entgegenhaltungen:
- WO-A1-2006/099754
- WO-A2-2008/138789
- US-A- 2 904 449
- US-A- 5 683 761
- US-A1- 2002 051 852
- US-A1- 2003 091 868
- US-A1- 2008 173 536
- GRASSET ET AL: "New nanocrystalline colored oxynitride thin films from Ti<4+> -functionalized ZnO nanocolloids", SUPERLATTICES AND MICROSTRUCTURES, ACADEMIC PRESS, LONDON, GB, vol. 38, no. 4-6, 1 October 2005 (2005-10-01), pages 300-307, XP005153757, ISSN: 0749-6036, DOI: 10.1016/J.SPMI.2005.08.023

## Beschreibung

Die Erfindung bezieht sich auf eine Beschichtung nach dem Oberbegriff des Anspruch 1.

Bekannt sind CVD Oxidschichten bzw. Schichtsysteme, die diese CVD Oxidschichten beinhalten, welche sehr breite Anwendung im Bereich der Zerspanung von Stahl und Gusseisen finden (CVD = chemical vapor deposition). Die Oxidschicht besteht dabei vorwiegend aus Aluminiumoxid in der Korundstruktur (alpha-Aluminiumoxid oder α-Al₂O₃), das bei Temperaturen um 1000°C auf den Werkzeugen abgeschieden wird. Die hohe Abscheidetemperatur (= Substrat- oder Werkzeugtemperatur) limitiert die Auswahl bei den Werkzeugmaterialien im Wesentlichen auf Hartmetalle wie Wolframkarbid oder auf Verbundwerkstoffe aus keramischen Werkstoffen in einer metallischen Matrix (sog. Cermets) oder auf hochtemperaturstabile Keramiken wie SiC oder SiN. In vielen Anwendungen, vor allem bei den Hartmetallwendeschneidplatten, wird das α-Al₂O₃ aber nicht direkt auf dem Werkzeug abgeschieden, sondern es wird zuerst eine TiCN-Schicht aufgebracht, die härter als das α-Al₂O₃ ist, aber weniger oxidationsbeständig. Dieses so aufgebaute Schichtsystem weist vor allem Vorteile auf, wenn mit dicken (> 15 µm) Schichtsystemen gearbeitet werden kann, was vor allem bei der kontinuierlichen Zerspanung von Grauguss der Fall ist. Bei unterbrochenen Schnitten sind die Zugspannungen in der Schicht, die durch die hohe Abscheidetemperatur und die temperaturbedingte Fehlanpassung zwischen Schichtmaterialien und Substrat auftreten, nachteilig. Es kommt zu Rissbildungen im Schichtsystem, teilweise schon vor dem Einsatz des Werkzeuges.

Der Vorteil des CVD Verfahrens, dicke Schichten auf relativ einfache und kostengünstige Weise herzustellen, kommt allerdings nicht zum Tragen, wenn es darum geht, besonders zähe Werkstoffe zu bearbeiten. In diesem Falle müssen sehr scharfe Werkzeugkanten vorgesehen werden und die Beschichtung darf nicht zu einer starken Vergrößerung des Werkzeugkantenradius führen, was bei den dicken CVD Schichten und der uniformen Schichtabscheidung der Fall ist.

Ein weiterer Nachteil besteht darin, dass es an der Schneide des Werkzeuges zu Materialaufschmierungen kommen kann, die unkontrollierten Kantenverschleiß fördern. Diese Aufschmierungen hängen vermutlich mit der Reaktionsfähigkeit des Ti in der Schicht zusammen. Es wurde nämlich beobachtet, dass sich Ti-Al-N Schichten bei Temperaturen zwischen 800°C und 900°C an der Oberfläche zersetzen und es zu einer porösen Oberflächenschicht geringer mechanischer Festigkeit kommt. Die chemische oder oxidative Schichtbeständigkeit dieses Materialsystems ist also bei diesen Temperaturen nicht mehr gewährleistet. Erfahrungsgemäß können solche Aufschmierungen drastisch reduziert werden, falls eine oxidische Schicht die nitridische Schicht zur Schichtoberfläche hin abschließt. Dies mit einem CVD Schichtsystem lösen zu wollen ist aus folgenden Gründen unbefriedigend: einmal dürfen aus den oben schon angeführten Gründen keine dicken Schichten abgeschieden werden, da sonst die scharfe Schneidkantengeometrie nicht eingehalten werden kann. Zweitens setzen sich die CVD Schichten üblicherweise aus TiCN und α-Al₂O₃ zusammen und beide Materialien sind in Härte und Zähigkeit einer guten Al-Ti-N Schicht unterlegen. Das würde bei vergleichbarer Schichtdicke vermutlich zu schlechteren Standzeiten führen. Und schließlich steht das CVD Schichtsystem unter Zugspannungen, was zumindest bei Anwendungen für unterbrochenen Schnitt zu früherem Schichtversagen führt.

Für die Anwendungsgebiete der schwer zerspanbaren Materialien wie beispielsweise von Titan und dessen Legierungen (beispielsweise mit Magnesium) sowie Nickelbasislegierungen (teilweise unter dem Handelsnamen Inconel® bekannt) sind Werkzeuge (z.B. Wendeschneidplatten) mit kleinem Schneidkantenradius, d.h. mit scharfkantiger Geometrie, gegenwärtiger Stand der Technik. Um die Kantenschärfe auch nach der Beschichtung nicht zu verlieren, sind deshalb dünne Schichten notwendig, die vorzugsweise mittels PVD hergestellt werden (PVD = physical vapor deposition). Natürlich ist hier auch die Gerichtetheit der PVD Beschichtung vorteilhaft, die es erlaubt, Span- und Freifläche einer Wendeschneidplatte durch entsprechende Substrathalterung mit unterschiedlicher Rate zu beschichten. Bevorzugt werden für diese Anwendungen Schichten aus Al-Ti-N eingesetzt, mit unterschiedlichen Metallanteilen. Dieses mittels PVD hergestellte Al-Ti-N Material besitzt neben hoher Zähigkeit auch gute Oxidationsbeständigkeit. Werkzeuge, die mit diesen verschleißmindernden Schichten beschichtet wurden, gelten heute als beste Lösung für Werkzeugbeschichtungen im Anwendungsbereich schwer zerspanbarer Materialien.

Die Zerspanungsparameter für solche Anwendungen unterscheiden sich allerdings deutlich von denen, die bei Normalstahl und Gusseisen verwendet werden. Typische Schnittgeschwindigkeiten für die Nickelbasislegierungen liegen bei 50 m/min und darunter, im Gegensatz zu einigen hundert Metern pro Minute im Stahl oder im Guss. Der Grund dafür ist die enorme mechanische und thermische Belastung der Schneidkante, zu der es bei den Anwendungen für schwer zerspanbare Materialien kommt. Deshalb wird an der Verbesserung der Werkzeugmaterialien, vor allem im Hinblick auf die Verbesserung der thermischen Leitfähigkeit gearbeitet. Eine Verbesserung der Werkzeugbeschichtung im Hinblick auf thermische Stabilität (Oxidationsbeständigkeit, chemische Stabilität und mechanische Festigkeit bei hohen Temperaturen) würde die geschilderten Probleme zusätzlich entschärfen helfen.

Ein Nachteil des gegenwärtigen Standes der Technik ist daher die geringe Produktivität bei der Zerspanung von schwer zerspanbarem Material, der durch die geringe Zerspanungsgeschwindigkeit bedingt ist.

Eine interessante Art des PVD - Beschichtens ist das Zerstäuben von Targets (sputtern). Dabei werden Ionen auf die Targetoberfläche beschleunigt und schlagen kleine Konglomerate aus dem Target heraus. Diese Möglichkeit ist beispielsweise in WO 2008/148673 beschrieben. Hier wird ein Zerstäubungsprozess (HIPIMS) vorgestellt, bei dem von einem oder mehreren AlMe Legierungstarget zerstäubt (gesputtert) wird, wobei gemäß einer Ausführungsform die abgeschiedene Schicht zwei Oxidphasen oder ein Mischoxid des Typs (Al₁₋ₓMeₓ)₂O₃ oder Spinell (Me)ₓAl₂O₃₊ₓ (0>x≤1) umfasst. Leider wird in dieser Veröffentlichung nicht angegeben, wie und durch welche Maßnahmen zwischen den zwei Oxidphasen und dem Mischoxid ausgewählt werden kann oder wie der Beschichtungsprozess geführt werden muss um zwischen dem Schichttyp (Al₁₋ₓMeₓ)₂O₃ oder Spinell (Me)ₓAl₂O₃₊ₓ gezielt auszuwählen. Das Beispiel bestätigt die Möglichkeit der Herstellung eines Oxids des Typs (Al₁₋ₓMeₓ)₂O₃, nämlich alpha-Al₂O₃, es wird aber offen gelassen, wie andere Strukturen zu erzielen wären. Insbesondere stellt sich dem Fachmann die Frage, welche Maßnahmen getroffen werden müssen, damit die im Sputterprozess aus dem Target herausgeschlagenen Konglomerate beliebiger Struktur sich beispielsweise gezielt als Spinell (Me)ₓAl₂O₃₊ₓ auf den zu beschichtenden Substraten niederlässt.

Die Patentdokumente WO 2008/138789 und US 2002/0051852 beschreiben Hartstoffschichten für Schneidwerkzeuge.

Aufgabe der Erfindung ist es, eine Schicht zur Verfügung zu stellen, die im Wesentlichen die hohen Härten und Zähigkeiten des Ti-Al-N (oder Al-Ti-N) mit größerer thermischer Stabilität gegenüber chemischen Reaktionen bzw. Oxidation verknüpft. Zudem soll ein Schichtmaterial geschaffen werden, das hervorragende mechanische Eigenschaften aufweist, auch bei erhöhten Temperaturen.

Die Aufgabe wird mit den Merkmalen des Anspruch 1 gelöst. Vorteilhafte Weiterbildungen sind in Unteransprüchen gekennzeichnet.

Die Beschichtung, Schicht oder das Schichtsystem nach der Erfindung wird auf Schneidwerkzeugen abgeschieden, um den abrasiven, chemischen und oxidativen Verschleiß dieser Schneidwerkzeuge während des Zerspanungsvorganges zu vermindern. Bevorzugt wird diese oxidhaltige Schicht oder das Schichtsystem für Werkzeuge verwendet, die für die Zerspanung von sogenannten "schwierig zerpanbaren Werkstoffen" eingesetzt werden, wie beispielsweise für Titanlegierungen, hoch-nickelhaltigen Stahllegierungen und einigen Arten von rostfreien Stählen mit speziellen Legierungen, die die Härte und den chemischen Verschleiß der Werkstoffe erhöhen.

Die Schicht oder das Schichtsystem kann auch für katalytische Zwecke Anwendung finden.

Vorteilhafterweise weisen die Feststoffmaterialien, aus denen die Schicht besteht, sowohl als Oxid wie als Nitrid eine ähnliche Kristallstruktur auf und kristallisieren bevorzugt in kubischer Struktur, das Oxid bevorzugt zumindest teilweise in kubischer Struktur des Spinell.

Ein Ziel dieser Erfindung ist es, dass die Schicht so ausgestaltet ist, dass neben den Oxiden mit Spinellstruktur auch noch Anteile anderer Oxide eingebracht werden können, die sich aus den Feststoffanteilen des benutzten Funkentargets bilden lassen. Diese Oxide sollen möglichst eine feinkristalline oder amorphe Struktur aufweisen und damit zur Verbesserung der mechanischen Schichteigenschaften dienen, besonders bei erhöhten Temperaturen. Beispielsweise soll erreicht werden, dass sie die Bruchfestigkeit der Schicht erhöhen und mechanische Spannungen reduzieren, die durch die verschiedenen Ausdehnungskoeffizienten zwischen der funktionalen Oxidschicht und den Stütz- und Haftschichten sowie dem Substrat (Werkzeug) entstehen können.

Erfindungsgemäß können Multilagenschichten hergestellt werden, die im Wesentlichen in einer Kristallstruktur synthetisiert werden.

Mit der erfindungsgemäßen Schicht oder dem Schichtsystem sollen neben den Werkzeugen aus hochtemperaturbeständigen Materialien wie Hartmetall (cemented carbide), Verbundwerkstoffen (cermets), Diamant, Keramiken aus SiC (silicon carbide), SiN (silicon nitride), c-BN (cubic boron nitride) auch weniger temperaturfeste Materialien aus HSS (high speed steel) oder anderen Stahllegierungen sowie Bauteile aus Aluminium mit Vorteil beschichtet werden können.

Erfindungsgemäß wird die Aufgabe durch eine Beschichtung nach Anspruch 1 gelöst. Gemäß einer bevorzugten Ausführungsform beinhaltet eine erfindungsgemäße Schicht NiAl₂O₄ in Spinellstruktur sowie Aluminiumoxid in zumindest einer der Phasen aus der Gruppe röntgenamorph, Korundstruktur, gamma Phase, kappa Phase oder theta Phase. Gemäß einer weiteren bevorzugten Ausführungsform beinhaltet die erfindungsgemäße Schicht NiAl₂O₄ in Spinellstruktur sowie einen NiO Bestandteil, der vorzugsweise in röntgenamorpher Phase vorliegt.

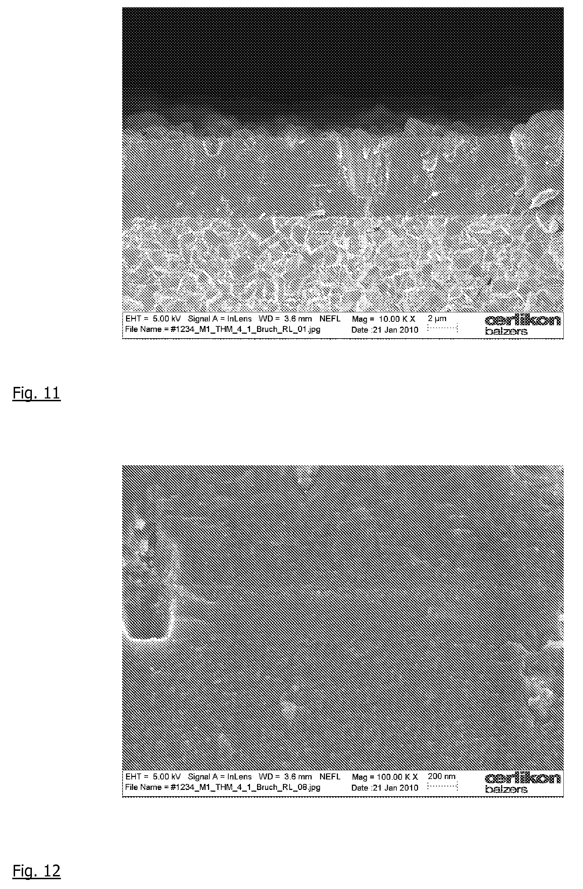

In einer weiteren besonders bevorzugten Ausführungsform der vorliegenden Erfindung lassen sich bei XRD Messungen an der Schicht zumindest 2 Reflexe, bevorzugt jedoch 3 Reflexe messen, welche mit in der in Fig. 11 gegebenen Referenz 01-077-1877 des NiAl₂O₄ im Wesentlichen übereinstimmen und im Wesentlichen nicht vom Substrat herrühren. Vorzugsweise sind das die Reflexe der [3 1 1] Ebene bei 2θ = 37,0°, der [4 0 0] Ebene bei 2θ = 45,0° und der [5 1 1] Ebene bei 2θ = 59,6°. In der ganz besonders bevorzugten Ausführungsform der vorliegenden Erfindung zeigt das Röntgenspektrum im Winkelbereich von 20° ≤ 2θ ≤ 90° neben den Reflexen des Substrates im Wesentlichen nur Reflexe der NiAl₂O₄ Referenz 01-077-1877 der Fig. 11.

In einer weiteren bevorzugten Ausführungsform liegt ein Multischichtsystem vor, welches Schichten mit NiAl₂O₄ in Spinellstruktur und zusätzlich metallische Oxide und/oder Nitride enthält, wobei sich in benachbarten Schichten die metallischen Anteile prozentual unterscheiden. Aufgrund des Multischichtdesigns wird die Zähigkeit erhöht. Dadurch gibt es im Wesentlichen keine Dickenbegrenzung mehr. Außerdem kann die dem Schichtsystem inhärente Energie erhöht werden, was zu größeren Härten führt. Erfindungsgemäß kann das die NiAl₂o₄ in Spinellstruktur enthaltende Multischichtsystem auch abwechselnd eine oder mehrere zusätzliche kristalline und amorphe Oxidphasen, vorzugsweise Hochtemperaturphasen enthalten.

In einer weiteren Ausführungsform der vorliegenden Erfindung sind Gradientenschichten realisiert, die NiAl₂O₄ in Spinellstruktur mit konstanter Gitterkonstante umfassen und der Anteil einer vorliegenden amorphen Phase innerhalb der Schicht stufenweise und/oder kontinuierlich variiert.

Die Erfinder haben überraschenderweise festgestellt, dass sich die erfindungsgemäßen Schichten in wirtschaftlicher Weise mittels Funkenverdampfen herstellen lassen. Beim Funkenverdampfen entstehen sogenannte Droplets. Das sind Konglomerate von nicht vollständig durchoxidierten oder nicht vollständig durchnitrierten metallischen Bestandteilen oder intermetallischen Verbindungen, die vom Target herrühren. Besonders wirtschaftlich ist die Herstellung erfindungsgemäßer Schichten dann, wenn auf die Filterung solcher Droplets verzichtet werden kann. Eine Schicht, welche solche Droplets aufweist, kann daher als mittels Funkenverdampfen hergestellte Schicht identifiziert werden. Gemäß einer Ausführungsform der vorliegenden Erfindung weisen daher die NiAl₂O₄ in Spinellstruktur umfassenden Schichten die für das Funkenverdampfen typischen Droplets auf. Insbesondere lassen sich mittels Funkenverdampfen hergestellte Schichten erzeugen, die NiAl₂O₄ in Spinellstruktur oder kubischer Struktur umfassen, deren Droplets mehrheitlich, vorzugsweise im Wesentlichen alle, einen metallischen Anteil von weniger als 50at% Nickel aufweisen.

Die Erfindung wird anhand einer Zeichnung beispielhaft erläutert, es zeigen dabei:
- Fig. 1:: einen Vergleich der XRD-Spektren der Proben1215 und 1217, die mit unterschiedlichem Sauerstofffluss hergestellt wurden, aber nahezu identische Reflexe zeigen;
- Fig. 2:: einen SEM-Querschnitt an Probe 1216, der die NiAl₂O₄ Schicht mit der ca. 150 nm dicken Chromhaftschicht zeigt;
- Fig. 3:: einen Vergleich der XRD-Spektren der Proben 1214 und 1216, die mit unterschiedlichem Sauerstofffluss und Chrom-Haftschicht hergestellt wurden und wiederum nahezu identische Reflexe zeigen, es gibt kein Hinweis dafür, dass die Chrom-Haftschicht die Spinell-Struktur des NiAl₂O₄ beeinflusst;
- Fig. 4:: einen Vergleich der XRD-Spektren der Proben 1214 und 1216, die mit unterschiedlichem Sauerstofffluss und Chrom-Haftschicht hergestellt wurden und wiederum nahezu identische Reflexe zeigen, wobei die besser aufgelöst dargestellte 2θ Skala zeigt, dass das Chrom-Peak der Haftschicht weder auf dem WC-Reflex des Substrates noch auf dem des NiAl₂O₄ liegt;
- Fig. 5:: ein RBS-Spektrum der Probe 1217 mit berechneter Schichtzusammensetzung;
- Fig. 6:: ein RBS-Spektrum der Probe 1216 mit berechneter Schichtzusammensetzung;
- Fig. 7:: ein RBS-Spektrum der Probe 1215 mit berechneter Schichtzusammensetzung;
- Fig. 8:: ein RBS-Spektrum der Probe 1214 mit berechneter Schichtzusammensetzung;
- Fig. 9:: einen Vergleich der XRD-Spektren von Probe 1217 (Ni-Al₂O₄) mit der synthetisierten Ni-Al-N Schicht (Probe 1231), die Reflexe des Oxids und Nitrids liegen etwa an gleicher 2θ Stelle;
- Fig. 10:: einen Vergleich der XRD-Spektren von Probe 1217 (Ni-Al₂O₄) mit der synthetisierten Ni-Al-N Schicht (Probe 1231, die in besser aufgelöster 2θ Skala nochmals die Übereinstimmung der Oxid- und Nitridpeaks zeigen;
- Fig. 11:: eine SEM-Querschnittsaufnehma eines Schichtsystems aus einer Al-Ti-N Stützschicht und einer erfindungsgemäßen Ni-Al-O Funktionsschicht;
- Fig. 12:: eine Vergrößerung eines Bereichs von Fig. 11 zwischen den Schichten;
- Fig. 13:: Referenzdaten für NiAl₂O₄ (Referenz 01-077-1877);
- Fig. 14:: Referenzdaten für Cr (Referenz 01-089-4055);
- Fig. 15:: Materialkenngrößen Probe 1214;
- Fig. 16:: Materialkenngrößen Probe 1215;
- Fig. 17:: Materialkenngrößen Probe 1216;
- Fig. 18:: Materialkenngrößen Probe 1217;
- Fig. 19:: Beispiele synthetisierter Schichtsysteme, die NiAl₂O₄ Material enthalten, als Haftschicht kommt beispielsweise auch Cr, CrN, AlCrN, Ni-Al-N, Ni-Cr-N, TiN, ZrN oder VN in Frage, als Stützschicht kommt beispielsweise auch TiCN in Frage.

Die Erfindung beruht auf Experimenten, die in einer Funkenverdampfungsanlage des Typs Innova der Firma OC Oerlikon Balzers AG gemacht wurden. Als Substrate für die Beschichtung wurden Wendeschneidplatten aus Hartmetall (WC basierend) und Verbundwerkstoffen (Cermets) benutzt. Die Funkenquellen wurden mit Ni-Al Targets bestückt. Im beschriebenen Fall wurden pulvermetallurgisch hergestellte Targets benutzt. Aber auch auf andere Art hergestellte Targets, die die Kombination von Ni und Al im Target enthalten, können für dieses Verfahren verwendet werden, beispielsweise schmelzmetallurgisch hergestellte oder plasmagespritzte Targets. Zusätzlich wurde zudem noch mit Targets mit anderen Materialien gearbeitet, um die jeweilige Haftschicht oder Stützschicht herzustellen oder um deren Feststoffe in den Übergang zur Funktionsschicht oder in die Funktionsschicht selbst einzubauen.

Das prinzipielle Verfahren der Funkenverdampfung zur Oxidherstellung ist bekannt. Vorliegend soll daher lediglich grob auf die Grundprinzipien des Funkenverdampfens eingegangen werden.

Beim Funkenverdampfen wird in der Regel in einer Vakuumkammer ein Plasma in Form einer Hochstrom-Niederspannungs-Lichtbogenentladung auf einer Werkstoffquelle, im folgenden Target genannt, erzeugt. Der zu verdampfende Werkstoff wird bei diesem Prozess als Kathode an den negativen Pol einer Spannungsquelle gelegt. Beispielsweise mittels einer Zündeinrichtung wird der Lichtbogen gezündet. Der Lichtbogen schmilzt die Kathode an einem oder mehreren Kathodenflecken, in denen sich der Stromübergang konzentriert. Dabei werden im Wesentlichen Elektronen aus der Kathode herausgezogen. Um den Lichtbogen aufrecht zu erhalten, muss daher ständig für Elektronennachschub an der entsprechenden Kathodenoberfläche gesorgt werden. Der Lichtbogen, oder bedeutungsgleich auch Arc genannt, bewegt sich auf der Kathodenfläche. Es kommt zu einem extrem schnellen Aufheizen kleiner Targetoberflächenbereiche, wodurch lokal Material verdampft wird.

Für eine tiefergehende Beschreibung sei auf die vom gleichen Anmelder eingereichten Patentanmeldungen, wie beispielsweise WO 2006/099760, WO 2006/099759, WO 2008/009619, WO 2006/099758 oder WO 2008/043606 verwiesen.

Zur Herstellung der erfindungsgemäßen Oxidschicht (Funktionsschicht) wurden zusammengesetzte Ni-Al-Targets verwendet, die Nickel-Anteile zwischen 10 at% und 80 at% aufwiesen, vorzugsweise zwischen 20 at% und 60 at%.

Als Reaktivgas für die Funktionsschicht wurde während der Funkenverdampfung entweder reiner Sauerstoff benutzt oder ein Gemisch aus Sauerstoff und Stickstoff, beides sowohl mit als auch ohne Argon-Beimischung. In den Übergängen zwischen der Haft- oder Stützschicht und der Funktionsschicht wurde meist Stickstoff oder ein Gemisch aus Stickstoff und Sauerstoff, wieder mit optionaler Zugabe von Argon, verwendet. Die Auswahl und Zugabe der Gase richtet sich danach, welche chemische Zusammensetzung der zu synthetisierenden Schicht angestrebt wird: reiner Stickstoff für ein Nitrid, reiner Sauerstoff für ein Oxid oder eine Mischung aus beiden Gasen für ein Oxinitrid. Dem Fachmann auf dem Gebiet der PVD Beschichtung ist bekannt, dass auch andere Reaktivgase der Funkenverdampfung beigegeben werden können, beispielsweise C₂H₂ als ein Beispiel eines kohlenstoffhaltigen Gases, um Karbide, oder ein Gemisch von C₂H₂ und Stickstoff, um Karbonitride zu erzeugen. Von diesen Möglichkeiten wird vor allem bei der Haft- und/oder Stützschicht Gebrauch gemacht. Die Gasflüsse für das oben angeführte Beschichtungssystem werden durch Gasflusskontroller geregelt. Zusätzlich besteht auch noch die Möglichkeit der Regelung der Gase über den Kammertotaldruck (Druckregelung), wovon in einigen Fällen der Schichtherstellung auch Gebrauch gemacht wurde. Typische Kammertotaldrucke lagen zwischen 0,3 Pa und 10 Pa, typische Gasflüsse zwischen 0 und 2000 sccm.

Die Funkenströme wurden in großen Bereichen variiert. Zur Abscheidung der Funktionsschicht wurde mit Strömen zwischen 60 A und 350 A gearbeitet, wobei sowohl DC wie gepulste Funkenströme verwendet wurden. Der Bereich der bevorzugten Funkenströme liegt zwischen 80 A und 200 A.

Es wurden Substrate in einem Substrattemperaturbereich zwischen 200°C bis 600°C beschichtet, die mit Substratbias zwischen -20 und -300 V beaufschlagt wurden. Vorzugsweise wurde mit bipolar gepulstem Substratbias gearbeitet, vor allem während der Beschichtung mit den Oxidschichten.

Dem eigentlichen Beschichtungsschritt vorausgehend wurden die dem Fachmann bekannten im Vakuum stattfindenden Vorbehandlungen von Heiz- und Ätzschritten durchgeführt, um die bereits außerhalb des Vakuums gereinigten Substrate noch einer weiteren Vorbehandlung im Vakuum zu unterziehen.

Nach diesen Vorbehandlungsschritten erfolgt die Beschichtung der Substrate mit den Schichten, die vor der eigentlichen Funktionsschichtabscheidung erfolgen. Üblicherweise ist das eine Schicht, die als Zwischen - oder Haftschicht (interface) für die spätere Schicht oder das spätere Schichtpaket dient. Typische bekannte Materialien für diese Haftschicht sind Al, Ti, Cr, Zr, Nb sowohl in metallischer Form wie auch als Nitride. Um die Haftung in einigen Fällen für bestimmte Werkzeuge (Substrate) zu verbessern, können diese Schichten gemäß einer Ausführungsform der vorliegenden Erfindung Ni und/oder Co enthalten. Auch Kombinationen dieser Materialien und deren Nitride führen in vielen Fällen zu verbesserter Schichthaftung. Als Beispiele sollen Ni-Cr, Ni-Al, Al-Ni-Cr, Zr und deren Nitride genannt werden, ohne dass diese Aufzählung beschränkend verstanden werden soll.

Nach der Zwischen- oder Haftschicht kann es je nach Anwendung sinnvoll sein, weitere Schichten vor der eigentlichen Funktionsschichtabscheidung aufzubringen. Diese können beispielsweise dazu dienen, einen angepassten Übergang zur Funktionsschicht zu schaffen. Sie können aber auch die Verschleißbeständigkeit des gesamten Schichtpaketes erhöhen, also selbst von funktioneller Bedeutung sein. Dem Fachmann bekannt sind Nitride und Karbonitride aus den Elementen Al, Ti, Cr, Zr und Nb und Nitride und Karbonitride aus jeweils zwei solcher Elemente (z.B. AlTiN oder AlCrN) erwiesen. Als besonders vorteilhaft hat sich erwiesen, wenn diese Schichten auch Ni und/oder Co enthalten.

Zur Beschichtung der Haftschicht und/oder der Stützschicht werden entweder elementare metallische Targets benutzt, die aus den oben angeführten Metallen bestehen oder zusammengesetzte Targets, die aus Mischungen zweier oder mehrerer Elemente hergestellt werden, beispielsweise pulvermetallurgisch oder als Legierung oder als intermetallische Verbindung oder durch Plasmaspritzen.

Schließlich erfolgt die Beschichtung des mit Haftschicht und Stützschicht beschichteten Substrates mit der eigentlichen Funktionsschicht. Der Übergang von der Haft- oder Stützschicht zur Funktionsschicht kann dabei fließend oder abrupt gestaltet werden. Fließende Übergänge können beispielsweise erzielt werden, indem sowohl die Targets, die für die Haftschicht oder die Stützschicht benötigt wurden, noch eine zeitlang gemeinsam mit den Targets der Funktionsschicht betrieben werden und es somit zu einer Mischschicht im Übergang kommt. Eine andere Möglichkeit eine Mischung bzw. einen gradierten Übergang zu erzeugen, besteht durch das Rampen der Gasflüsse. Falls für die Haft- oder Stützschicht eine nitridische Schicht abgeschieden wurde, können die Targets der Funktionsschicht anfänglich im Stickstoff betrieben werden, der dann gradiert oder abrupt, beispielsweise durch Sauerstoff, ersetzt wird, um von einem Nitrid in ein Oxinitrid und dann in das reine Oxid überzugehen.

Als eine erste bevorzugte Variante der Funktionsschicht wird eine Ni-Al-Oxidschicht abgeschieden. Für die Beschichtung wurden Ni-Al-Mischtargets mit einer Mischung aus 30 at% Nickel und 70 at% Al benutzt und die Verdampfung des Targetmaterials erfolgt in reiner Sauerstoffatmosphäre. Die Sauerstoffflüsse werden dabei aus dem weiter oben angegeben Bereich gewählt. Die Targets können wiederum pulvermetallurgisch oder als Legierung oder als intermetallische Verbindung oder durch Plasmaspritzen hergestellt worden sein. Im vorliegenden Experiment wurde mit pulvermetallurgischen Targets gearbeitet. Es soll hier daran erinnert werden, dass Nickel magnetische Eigenschaften aufweist. Dies kann zu einer unerwünschten Führung des Funkens auf dem Target führen. In der Praxis hat sich dies bisher nicht gezeigt, weil die Zugabe von Sauerstoff oder Stickstoff sich stabilisierend auf die Funkenentladung auswirkt. In besonders kritischen Fällen kann ein gepulster Funkenbetrieb diese Stabilisierung weiter unterstützen.

Als Ergebnis dieser Synthese erhält man überraschenderweise eine Oxidschicht, deren Röntgenspektrum auf eine kubische Struktur hinweist und das beim Vergleich mit der Datenbasis zweifelsfrei der Verbindung NiAl₂O₄ zugeordnet werden kann. Überraschend ist dieses Ergebnis vor allem auch deshalb, weil keine Bragg-Reflexe anderer Oxide gefunden wurden, weder Reflexe von irgendwelchen Aluminiumoxiden noch von Nickeloxiden.

Dabei ist dem Fachmann bekannt, dass sich das α-Al₂O₃ bei etwa 1000°C bildet, wohingegen sich das NiAl₂O₄ erst bei höheren Temperaturen über 1300°C mit brauchbaren Raten formiert. Man würde also erwarten, dass sich die Korundphase des Al₂O₃ eher bildet als die Spinell Phase des NiAl₂O₄.

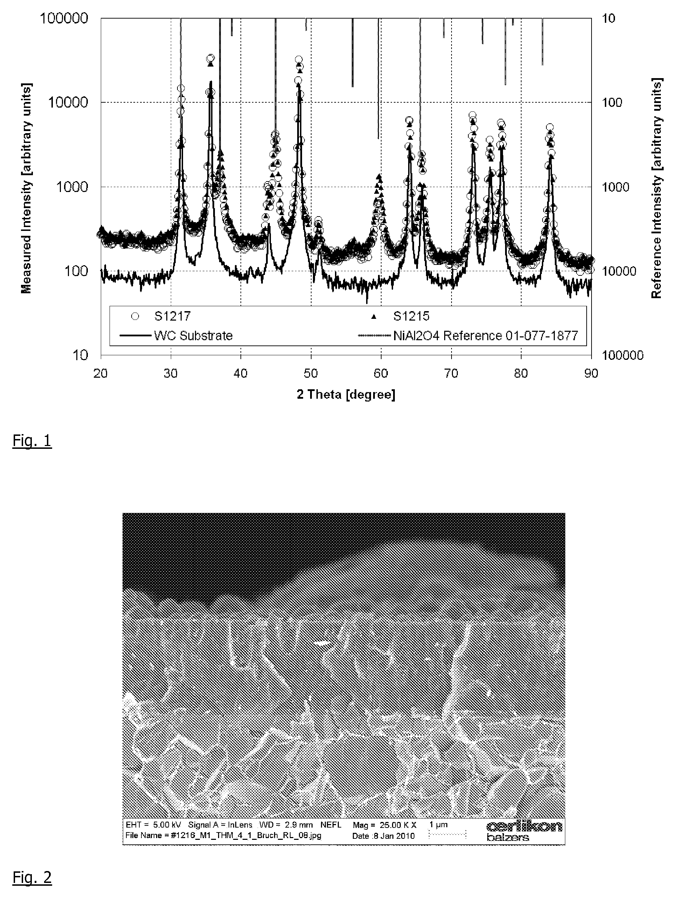

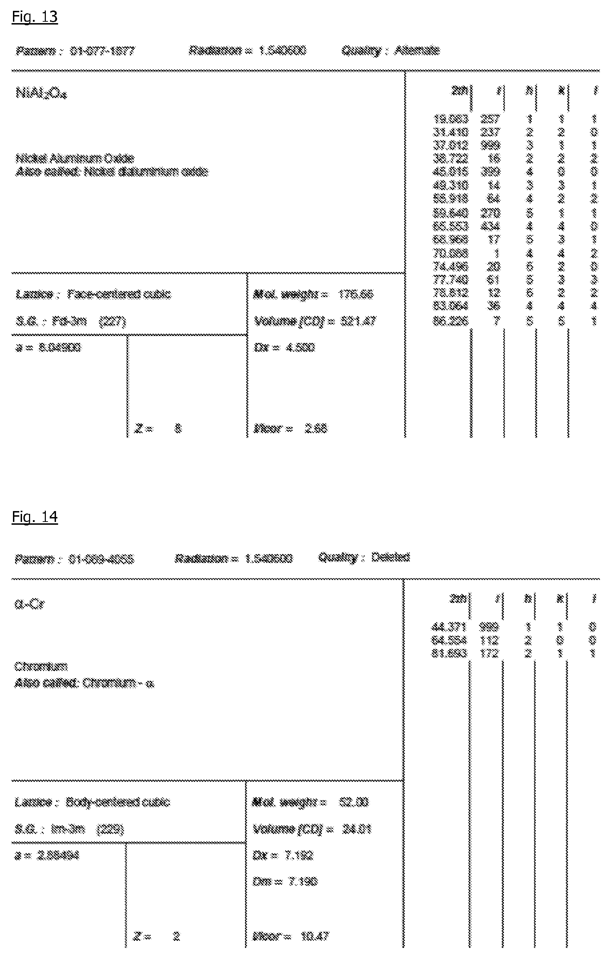

Es wurden eine Reihe dieser Ni-Al-Oxidschichten hergestellt und daran Analysen vorgenommen. In Abbildung 1 werden die XRD Spektren von Ni-Al-Oxidschichten gezeigt, die mit unterschiedlichen Sauerstoffflüssen hergestellt wurden. Es wurde eine logarithmische Darstellung für die Intensität der gestreuten Röntgenstrahlen gewählt, um zwischen Substrat und den beschichteten Substraten besser unterscheiden zu können. Das XRD Spektrum des unbeschichteten WC-Substrates (Wendeschneidplatte) ist als Linie mit ausgeprägtem Rauschen zu sehen. Als Vergleich dazu sind die XRD Spektren der beschichteten Substrate mittels Kreis- und Dreieckssymbole dargestellt. Die Messpunkte der Probe 1215 wurden mit offenen Dreieckssymbolen dargestellt und die Messwerte der Probe 1217 mit offenen Kreissymbolen. Aus der XRD Datenbank wurde als Vergleich ein NiAl₂O₄ Spektrum (01-077-1877, Fig. 13) in Balkenform von oben kommend (schwarze Linien) zusätzlich in die Abbildung eingefügt, wobei die Balkenlängen die relativen Intensitäten der Röntgenreflexe der Referenzprobe untereinander widerspiegeln. Alle Reflexe des Röntgenspektrums beider beschichteter Substrate lassen sich zuordnen. Den Referenzdaten können die im gemessenen Spektrum dominanten (311), (400) und (511) Reflexe problemlos zugeordnet werden. Zusätzlich zu diesen dominanten Reflexen findet man noch die Reflexe (331) und (422), sowie Andeutungen von (531) und (442) mit geringerer Intensität. Zur Überlappung mit den Substratreflexen kommt es für die (220), (440) und (444) Reflexe. Die XRD Analyse verdeutlicht demnach, dass mittels reaktiver Funkenverdampfung eine kristalline Schicht aus Ni-Al₂O₄ synthetisiert werden kann, die kubische (Fd-3m) oder Spinellstruktur aufweist. Diese Synthese erfolgte im vorliegenden Beispiel bei 550°C Substrattemperatur. Diese Substrattemperatur liegt deutlich unter der Bildungstemperatur dieser Verbindung im thermischen Gleichgewicht.

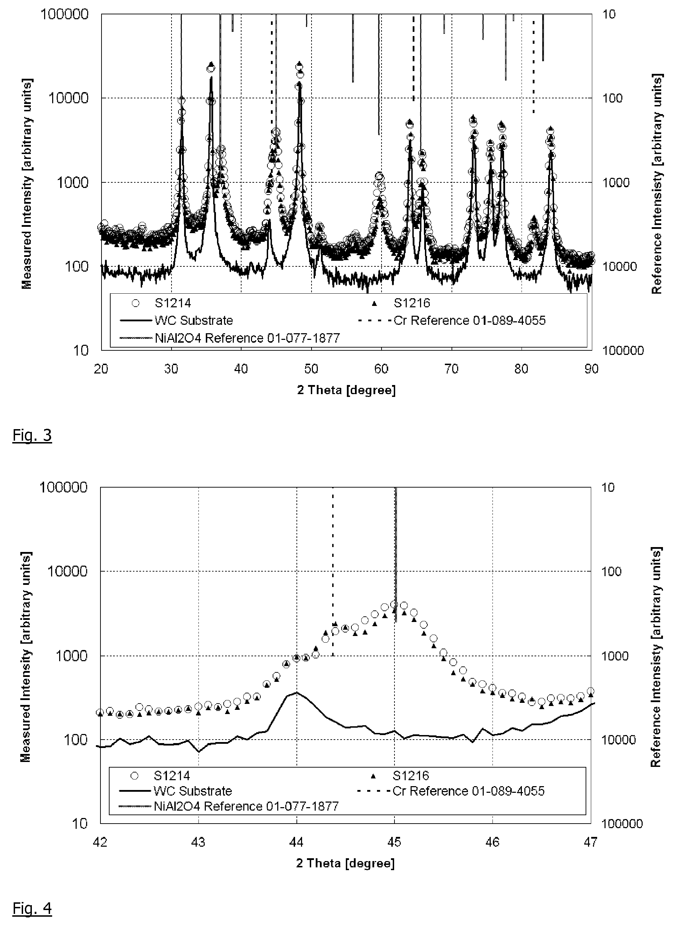

Die in Fig. 1 gezeigten Schichten wurden mit unterschiedlichen Reaktivgasflüssen synthetisiert, aber ohne Haftschicht direkt auf dem WC-Substrat abgeschieden. Wie schon vorher diskutiert, zeigt die Fig. 1 die Überlappung einiger Substratreflexe mit den Schichtreflexen. Um nun weitgehend auszuschließen, dass die Schicht nur deshalb in Spinellstruktur synthetisiert werden konnte, weil es zu dieser "Nukleationshilfe" des Substrates kommt, wurden beide Beschichtungen in ansonsten identischen Prozessen, aber mit einer zusätzlichen ca. 150 nm dicken Chrom-Haftschicht hergestellt. Probe 1214 wurde wieder mit 300 sccm und Probe 1216 wieder mit 800 sccm Sauerstofffluss hergestellt. In Fig. 2 wird die SEM-Aufnahme eines Bruchquerschnittes an der Probe 1216 gezeigt und man kann die dünne Haftschicht erkennen. Das Ergebnis der XRD-Analyse an diesen Schichten ist in Fig. 3 dargestellt. Für das Chrom wurde aus der XRD-Datenbank wieder ein Referenzspektrum (01-089-4055, Fig. 14) ausgewählt, welches eine Im-3m (kubisch raumzentrierte) Struktur aufweist. Dieses Spektrum erklärt wie zu erwarten die zusätzlichen Peaks im Spektrum, die von der Chrom-Haftschicht stammen. Die Chrom Peaks der Referenz sind als graue Balken dargestellt. Bei der geringen Ni-Al-O Schichtdicke von ca. 2 µm ist das Cr noch gut messbar. Der (211) Peak des Cr zeigt keine Überlappung mit Substratpeaks. Der (110) Peak lässt sich gut trennen, wenn man die 2θ-Skala besser auflöst, wie es in Fig. 4 getan ist. Bei dieser besseren Auflösung sieht man eine deutliche Trennung des Substratpeaks vom (110) Cr-Peak und vom (400) NiAl₂O₄-Peak. Das (200) Peak des Cr zeigt allerdings wieder Überlappungen mit dem Substratpeak. Da sich für alle Proben 1214 bis 1217 die gemessenen Schichtpeaks von NiAl₂O₄ praktisch bei denselben 2θ-Werten finden, wie der Vergleich von Fig. 1 und 3 zeigt, kann man schlussfolgern, dass es zu einer Bildung von NiAl₂O₄ kommt, gleichgültig, ob mit oder ohne Haftschicht vor der Schichtabscheidung der Ni-Al-O Funktionsschicht gearbeitet wird, es also keine Nukleationsschicht benötigt.

Es wurde auch die chemische Zusammensetzung der Schichten, die mit 300 sccm und mit 800 sccm Sauerstoffflüssen hergestellt wurden, analysiert. Die Analyse erfolgte mittels EDX und RBS Messungen. Da für die metallischen Zusammensetzungen kein wesentlicher Unterschied zwischen der EDX und der RBS Analyse gefunden werden konnte, sollen hier nur die RBS Messungen diskutiert werden, weil diese sowohl quantitativ besseren Aufschluss über den Sauerstoffgehalt geben und auch qualitativ das Tiefenprofil der Metalle in der Nähe der Schichtoberfläche beschreiben.

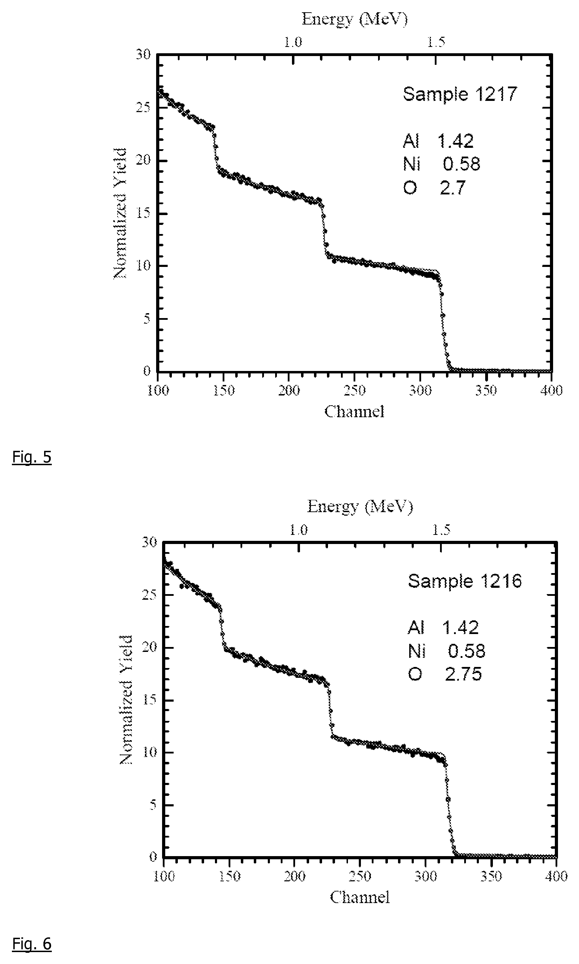

In Fig. 5 wird das RBS Spektrum der Probe 1217 gezeigt. Die Auswertung ergab eine Zusammensetzung von Ni_{0.58}Al_{1.42}O_{2.7}. Falls man das auf Nickel normiert, ergibt sich Ni₁Al_{2.45}O_{4.66}. Auf den ersten Blick scheint das eine Diskrepanz zu der XRD Analyse zu ergeben, da dort eindeutig die Peaks der Spinell-Struktur dem stöchiometrischen NiAl₂O₄ zugeordnet werden konnten. Erklären lässt sich dieser Sachverhalt dadurch, dass sich neben dem Ni-Al₂O₄ noch ein anderes oxidisches Material bildet. Basierend auf der Targetzusammensetzung ist natürlich das Aluminiumoxid naheliegend. Falls man also annimmt, dass sich stöchimetrischer Spinell formiert und die Differenz dazu bildet, erhält man Als_{0.45}O_{0.66} oder anders normiert Al₂O_{2.94}, was innerhalb der Fehlergrenzen dem stöchiometrischen Aluminiumoxid entspricht. Erwartungsgemäß erhält man für die Probe 1216 (Fig. 6) die gleiche Zusammensetzung, da diese ja auch, bis auf die Cr Haftschicht, in identischem Abscheideprozess für die Oxidfunktionsschicht hergestellt wurde.

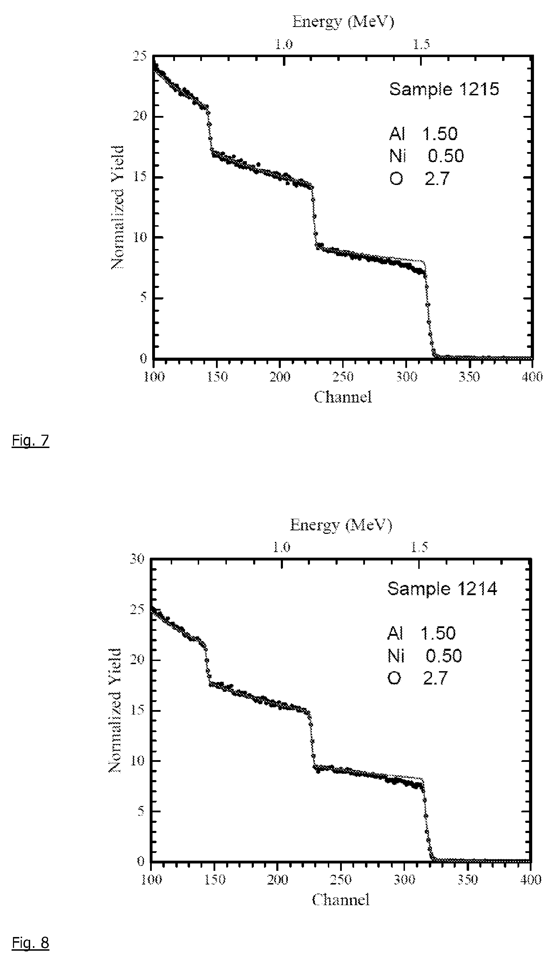

Ein anderes Resultat erhält man allerdings für die Probe 1215 (Fig. 7) und 1214 (Fig. 8), die mit geringerem Sauerstofffluss hergestellt wurde. Für beide Proben ergibt sich eine Zusammensetzung von Ni_{0.5}Al_{1.5}O_{2.7}, was bei einer Normierung auf Ni einer Zusammensetzung von NiAl₃O_{5.4} entspricht. Das lässt auf eine Schicht bestehend aus NiAl₂O₄ mit zusätzlichen Anteilen an AlO_{1.4} oder, was gleichbedeutend ist, Al₂O_{2.8} schließen, also wieder einem zusätzlichen Anteil von Aluminiumoxid in der Schicht.

Diese Messresultate unterstützen folgende Schlüsse. Einmal wird neben dem NiAl₂O₄ Spinell das zusätzlich im Target vorhandene Material in ein Oxid umgesetzt. Bestimmend für die Kristallstruktur ist aber der Spinell und das Aluminiumoxid liegt röntgenamorph vor, d.h. die Kristallitgröße ist zu klein, um in der Röntgenbeugung zu Reflexen zu führen. Zwar wurde an diesen Schichten keine Elektronenbeugung durchgeführt, aber es wird erwartet, dass eine solche Analyse feinkristallines Al₂O₃ mit Kristallitgrößen um 5 nm oder kleiner in einer Hochtemperaturphase (alpha, theta, gamma, kappa) zeigt.

Die zweite überraschende Schlussfolgerung betrifft die Abhängigkeit des Verhältnisses der metallischen Anteile in der synthetisierten Schicht. Während für die Schichten mit 300 sccm Sauerstofffluss (Proben 1214 und 1215) ein Al/Ni Verhältnis von 3,0 gemessen wurde (und zwar im oberflächennahen Bereich), erhält man für 800 sccm Sauerstofffluss (Proben 1216 und 1217) ein Al/Ni Verhältnis von 2.5. Das bedeutet, dass sich über den Sauerstofffluss die Konzentration der Targetbestandteile Ni und Al in der Schicht steuern lässt (bei gleichen Targetkonzentrationen der metallischen Bestandteile!). Die Möglichkeit, dass sich die Targetoberfläche nach mehreren Stunden Funkenbetrieb noch immer nicht im "Gleichgewicht" (d.h. dass die Oberfläche des pulvermetallurgisch hergestellten Targets noch nicht konditioniert war) befand, kann man mit der Erfahrung aus anderen Beschichtungsprozessen mit reaktiver Funkenverdampfung ausschließen. Das zeigen auch die im SEM mit elastisch rückgestreuten Elektronen aufgenommenen Targetoberflächen.

Nach den Experimenten zu urteilen wird der Sauerstoff vor allem für die NiAl₂O₄ Spinell-Struktur verbraucht und aus dem "Rest" des zur Verfügung stehenden Sauerstoffs Aluminiumoxid gebildet. Indem der Sauerstofffluss weiter auf 1200 sccm erhöht wurde, kam es dann praktisch zu einer dem Target entsprechend stöchiometrischen Schichtbildung, was in vorliegenden Fall NiAl₂O₄ war. Es konnte nicht genau abgeklärt werden, warum es zu dieser Beeinflussung des Verhältnisses der Targetkomponenten über den Sauerstofffluss bezüglich der Schicht kommt.

Für Targets mit größeren Nickelgehalten (beispielsweise über 50 at%) wurde nachgewiesen, dass sich, neben der Bildung des NiAl₂O₄ Spinells, Nickeloxid und nicht Aluminiumoxid bildet. Auch in diesem Fall wurde wieder die Beeinflussung des Al/Ni Verhältnisses durch den Sauerstofffluss beobachtet.

Das Verfahren erlaubt bei gleicher Targetzusammensetzung Schichten mit unterschiedlichem Verhältnis der Metallkomponenten, die im Target vorhanden sind, insbesondere solche Mischoxidschichten herzustellen, indem der Sauerstofffluss reguliert wird.

Die bisher diskutierten Ergebnisse machen deutlich, wie wichtig es ist, dass bei der Synthese von NiAl₂O₄ Schichten weite Bereiche im Sauerstofffluss überstrichen werden können. Das Verfahren der reaktiven Funkenverdampfung bietet deshalb enorme Vorteile gegenüber reaktiven Sputterverfahren, die prinzipiell auch zur Schichtsynthese verwendet werden können, die aber verfahrensbedingt nicht die Möglichkeit haben, den Sauerstofffluss quasi unabhängig von der Prozessstabilität einzustellen. Dem Fachmann ist bekannt, dass beim Arbeiten im Sauerstoffgas nur enge Prozessfenster im Sputterbetrieb existieren, die eine Targetvergiftung vermeiden. Das Betreiben der Funkenquellen im reinen Sauerstoff und bei großen Sauerstoffflüssen bzw. Sauerstoffpartialdrucken beeinflusst auch den Konditionierungsprozess an den Targetoberflächen. Das ist von besonderer Bedeutung bei Mischtargets, die pulvermetallurgisch hergestellt werden. Nach der Zündung des Funkens kommt es zu einer deutlichen Modifikation der Targetoberfläche, die darauf schließen lässt, dass sich die elementaren Bestandteile an der Targetoberfläche in intermetallische Verbindungen oder Mischkristalle umwandeln. Je nachdem, ob dieser Prozess für die Schichtsynthese wünschenswert ist oder nicht, wird deshalb bei der Erstbenutzung der Targets mit oder ohne Targetblende gefahren, um einen Schichtaufbau am Substrat zu vermeiden oder ein Abbild der Konditionierung (eventuelle Nukleationsschicht) beim Schichtaufbau zu erzielen.

Die Temperaturstabilität der Oxidschicht mit der NiAl₂O₄ Spinell-Struktur wurde nachgeprüft, indem diese Temperaturzyklen bis zu 1100°C ausgesetzt wurden und die Stabilität der Röntgenspektren unter diesen Bedingungen beobachtet wurde. Es kam dabei zu keiner wesentlichen Veränderung der Spektren, die auf eine Änderung der Kristallstruktur des Spinells hinwies. Bei Temperaturen über 1000°C setzten lediglich Diffusionsvorgänge der Materialien aus der WC Hartmetallwendeschneidplatte ein, beispielsweise konnte die Diffusion des Co-Binders anhand von RBS-Analysen beobachtet werden.

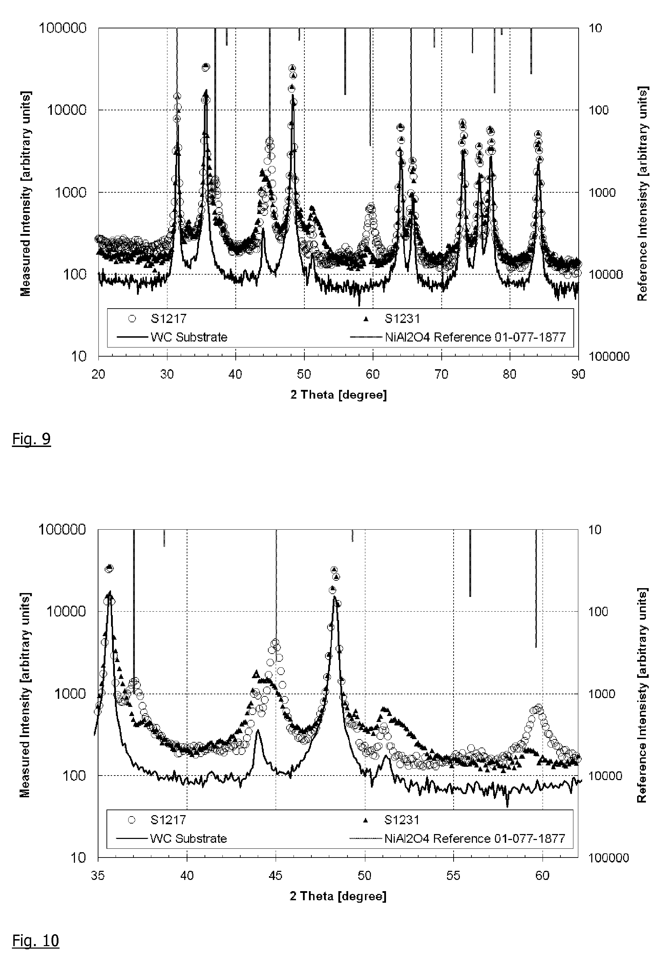

Die Qualität der Ankopplung der Ni-Al-Oxidschicht an das Substrat oder an die Haft- oder Stützschicht ist von entscheidender Bedeutung für die Leistung des beschichteten Werkzeugs oder Bauteiles. Man kann erfahrungsgemäß davon ausgehen, dass materialverwandte Schichtübergänge einen besonders guten Verbund schaffen. Es hat sich aber auch gezeigt, dass Materialien ähnlicher Kristallstruktur und Gitterkonstanten innigere Haftung zeigen als strukturfremde Materialien. Um nun die NiAl₂O₄ Schicht besonders gut an das WC-Substrat anzubinden wurde deshalb versucht, eine Ni-Al-N Schicht unter Benutzung der gleichen Targets herzustellen, die für die NiAl₂O₄ Oxidfunktionsschicht benötigt wurden. Es wurden also die Ni-Al Targets im Stickstoff betrieben (entweder flussgeregelt oder druckgeregelt). Von der auf diese Weise hergestellten Schicht wurde ein Röntgenspektrum erstellt. Fig. 9 zeigt das Ergebnis der XRD Messung dieser Schicht im Vergleich zur XRD Messung der Probe 1217. Zusätzlich ist wieder das Röntgenspektrum des WC-Substrates angegeben und die Balken zeigen wieder das NiAl₂O₄ Referenzspektrum. Für die Ni-Al-N Schicht konnte in der Datenbank kein Referenzspektrum gefunden werden, was darauf hinweist, dass diese Verbindung bisher noch nicht synthetisiert oder untersucht wurde. Der Vergleich ergibt, dass sich einige Peaks des Oxids und des Nitrids in etwa gleichen Positionen befinden, nämlich die (311), (400) und (511) Peaks (Oxidreferenz). Das wird deutlicher noch einmal in Fig. 10 dargestellt mit gespreizter 2θ Achse. Das Messresultat lässt auf ähnliche Kristallstrukturen schließen und vermuten, dass der Stickstoff durch den Sauerstoff graduell ersetzt werden kann und umgekehrt, ohne dass es zu großen Änderungen in der Kristallstruktur kommt, d.h. dass Ni-Al-N in ähnlich kubischer Struktur vorliegt wie das NiAl₂O₄. Dieses Messergebnis und die Materialähnlichkeit lassen gutes Ankopplungsverhalten zwischen Nitrid und Oxid erwarten. In den Experimenten wurden dementsprechend keine Haftungsprobleme zwischen der Ni-Al-N und der Ni-Al-O Schicht beobachtet und auch die Scratch Tests, die zum Zwecke der Quantifizierung der Haftung durchgeführt wurden, zeigten überdurchschnittlich gute Haftung.

Aber auch bei unterschiedlichen Materialien wurde eine ausgezeichnet Haftung vom Ni-Al-Oxid zur vorher abgeschiedenen Schicht beobachtet, falls das andere Material kubische Struktur aufwies. Vor allem konnte das für die Ankopplung an Ti_{0.5}Al_{0.5}N, Ti_{0.4}Al_{0.6}N sowie Ti_{0.34}Al_{0.66}N beobachtet werden und es wird vermutet, dass dies auch für weite Bereiche anderer Ti/Al Verhältnisse gilt, solange das Material vorwiegend kubische Struktur aufweist.

Als ein Beispiel ist in Fig. 11 die SEM Querschnittsaufnahme eines Schichtsystems dargestellt, dass aus einer Al-Ti-N Stützschicht und einer erfindungsgemäßen Ni-Al-O Funktionsschicht besteht. Eine höhere Vergrößerung des Bereiches zwischen den Schichten (Fig. 12) demonstriert den Übergang zwischen Nitrid und Oxid und zeigt, dass es zu keinen abrupten Änderungen in der Morphologie der Schichten kommt, was auf gute Haftung hinweist. Die Fig. 11 zeigt auch die bei der Funkenverdampfung typischen Droplets im Submikrometerbereich, die vor allem bei der Benutzung von mehrkomponentigen Targets auftreten. Die Keime der Droplets enthalten vor allem das Metall der hochschmelzenden Komponente des mehrkomponentigen Targets. In der Aufnahme sieht man auch größere Spritzer, die vor dem Beginn der Oxidbeschichtung generiert wurden und die bei geschickter Prozessführung stark verringert werden können. Man kann deren Zahl und Größe auf verschiedenen Weise reduzieren (z.B. durch die Benutzung von Quellenblenden mit Targetkonditionierung vor der Beschichtung bei geschlossener Quelle oder Abdecken der "Oxid"-Targets während der Nitridbeschichtung). Ganz vermeiden lassen sich diese Spritzer allerdings beim Arcverdampfen nicht, falls man die Substrate direkt den Quellen aussetzt und keine aufwendigen Filter verwendet.

Weitere Beispiele für Stützschichten mit kubischer Struktur sind TiN, CrN, TiCN und AlCrN, wobei diese Aufzählung als nicht einschränkend gelten soll. Besonders vorteilhaft sind Anpassungen an Materialien, die ein Vielfaches oder einen Teil der in Fig. 13 für das NiAl204 angegebenen Gitterkonstanten von a = 8.049 betragen. Dabei ist dem Fachmann geläufig, dass diese Gitterkonstante durch eine Variation der Konzentration der die Schicht bildenden Elemente "feinangepasst" werden kann bzw. dass es möglich ist über eine bestimmte Schichtdicke "fehlangepasst" (d.h. mit kleinem Unterschied in den Gitterkonstanten der aufeinanderliegenden Schichten) anzukoppeln. Der dabei in das Schichtsystem eingebaute Stress kann teilweise über ein Multilagendesign so gesteuert werden, dass es zu keiner Schichtablösung kommt.

Es ist deshalb vorteilhaft für die Leistung der Schicht, dass die Prozessführung eine unkomplizierte und sichere Herstellung von Schichten in Multilagenstruktur erlaubt. Mit der reaktiven Funkenverdampfung kann man Multilagenstrukturen auf ganz verschiedene Art herstellen. Die erste Methode besteht darin, dass man Targets unterschiedlicher Materialien wechselweise oder gleichzeitig räumlich in der Anlage versetzt betreibt. Zusätzlich kann noch das Reaktivgas variiert werden, also beispielsweise der Sauerstoff- oder Stickstofffluss oder deren Drucke. Besonders von Vorteil sind dann Materialien, die kubische Strukturen ausbilden, sowohl in den verschiedenen Materialien wie auch in den Reaktionsprodukten der Materialien mit den Reaktivgasen.

Eine weitere interessante Methode der Multilagenherstellung besteht darin, Targets zu benutzen, die aus den gleichen metallischen Komponenten bestehen (hier aus Ni-Al), aber bezüglich dieser unterschiedliche Zusammensetzung aufweisen. Auch diese können natürlich wechselseitig oder auch gleichzeitig mit unterschiedlichen Reaktivgasen betrieben werden. Das Ergebnis sind dann Multilagenschichten im gleichen Materialsystem, aber mit wechselndem Verhältnis der Targetbestandteile (Ni/Al Verhältnis) und entsprechender Reaktivgasanteile in der Schicht. Oder aber auch ein Multilagendesign, das neben dem wechselnden Verhältnis der Targetbestandteile zusätzlich noch durch unterschiedliche Reaktivgase erzeugt und überlagert wird.

Neuartig ist die Herstellung der Multilagenstrukturen durch die Benutzung gleicher Targets, die lediglich mit einer Variation des Sauerstoffflusses betrieben werden und zu deren Herstellung es prinzipiell auch keine Substratrotation erfordert, obwohl diese natürlich stattfinden kann. Wie schon weiter oben diskutiert, ändert sich mit dem Sauerstofffluss auch das Ni/Al Verhältnis, was Ursache für die Multilagenstruktur ist.

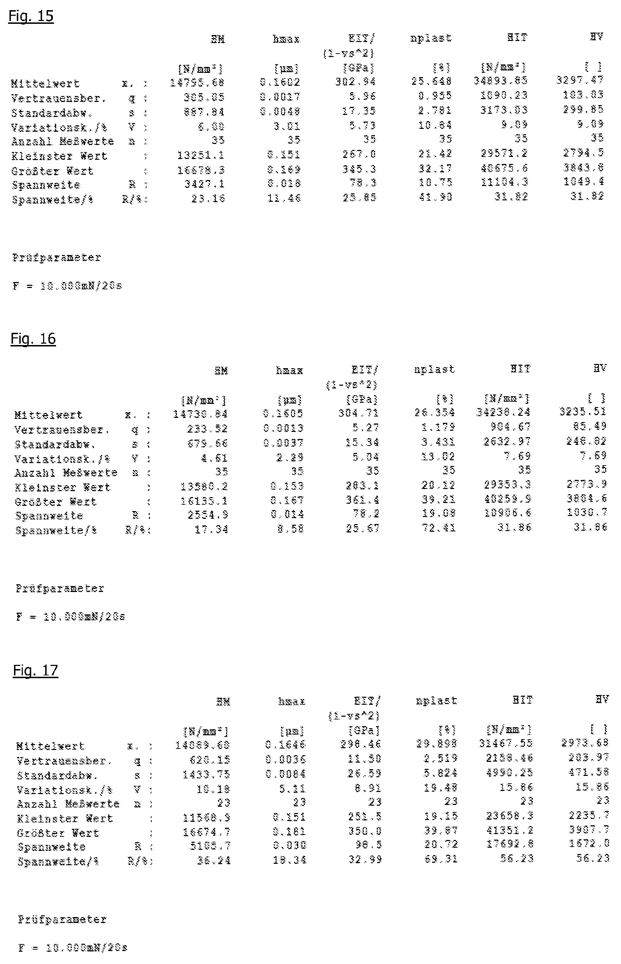

Die nach dem obigen Verfahren hergestellten Schichten wurden auf ihre mechanischen Eigenschaften hin getestet. Es kann selbstverständlich nicht auf alle Versuche eingegangen werden. Beispielhaft werden hier wieder nur die Ergebnisse der Proben 1214 bis 1217 angegeben, deren Martenshärte (HM) bei maximaler Prüfkraft, deren elastischer Eindringmodul (EIT/1-vs^2), deren plastischer Verformungsanteil (nplast), deren Eindringhärte (HIT) bei maximaler Prüfkraft und deren Härtewert nach Vickers (HV) gemessen wurden. Die Ergebnisse sind in den Fig. 15 bis 18 wiedergegeben. Die Schichten zeigen hervorragende Vickers-Härten von etwa 3200 für die Proben mit niedrigem Sauerstofffluss von 300 sccm und von etwa 3000 für den größeren Sauerstofffluss von 800 sccm. Der elastische Eindringmodul liegt im Vergleich zu anderen PVD Oxidschichten höher und ist sogar typisch für einige Nitride auf Al-Ti-Basis. Als Vergleich wurden auch noch Härtemessungen an einer Korundstandardprobe durchgeführt, die eine Vickershärte zwischen Hᵥ = 2500 bis 2700 ergaben. Diese Härtewerte liegen somit unter denen der erfindungsgemäßen Spinellschichten.

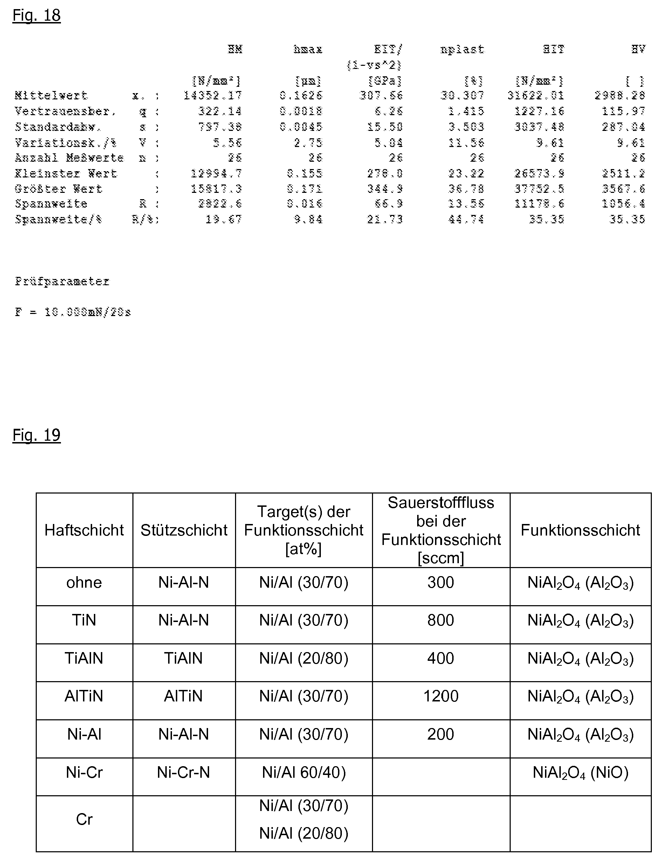

Um die Möglichkeiten bezüglich Schichtmaterialien, Schichtdesign und Herstellungsmethode zu demonstrieren, wurden verschiedene Schichtsysteme hergestellt, die in Fig. 19 dargestellt sind. Die Variationsmöglichkeiten sind groß und mit der Fig 19 sollen nicht alle möglichen Schichtsystem dargestellt werden. Fast alle Haftschichten lassen sich mit fast allen Stützschichtmaterialien kombinieren. Ökonomisch sinnvoll ist es aber, das gesamte Schichtsystem so auszulegen, dass die Zahl der Targets unterschiedlichen Materials möglichst klein gehalten wird, d.h. dass man alle Schichten mit einem Targetmaterial oder wenigstens Haft- und Stützschicht mit einem Material oder Stütz- und Funktionsschicht mit einem Targetmaterial beschichten kann. Die Schichtdicken wurden in der Fig. 19 nicht individuell angegeben, da sie über große Bereiche variiert werden können. Typische Dickenbereiche für die verschiedenen Schichten sind:
- Haftschicht: 0,05 µm bis 2 µm
- Stützschicht: 1 µm bis 15 µm
- Funktionsschicht: 1 µm bis 15 µm

Ebenfalls wurde nicht im Detail beschrieben, dass über den Substratbias der Stress in der Schicht verändert werden kann und dass bei höherem Substratbias Druckspannungen erzeugt werden, die noch größere Werte bei der Härtemessung ergeben, die aber zu Haftungsproblemen bei Schichtdicken über 10 µm führen können.

Die hohe Härte der Schichten und die Tatsache, dass diese die hochtemperaturstabile Spinell-Struktur ausbilden, ermutigten zu Zerspanungstests in schwer zerspanbarem Material, wie in austhenitischen Edelstählen und Nickelbasislegierungen, Titan und Titanlegierungen. Als ein Beispiel soll etwas näher auf die Zerspanung einer Nickelbasislegierung (Ni-Cr-Mo) eingegangen werden. Die Außenlängsdrehtests wurden auf gut geschliffenen Wendeschneidplatten mit glatten Oberflächen durchgeführt und verglichen wurde zwischen unbeschichteten, standardmäßig vom Hersteller beschichteten (Al-Ti-N basierend) und mit der erfindungsgemäßen Schicht beschichteten Wendeschneidplatten. Als Beispiel soll hier auf eine Stützschicht aus Ti_{0.34}Al_{0.66}N mit der NiAl₂O₄ Funktionsschicht eingegangen werden.

Es wurden Beschichtungen von 3 µm Schichtdicke (2 µm Stützschicht, 1 µm Funktionsschicht) an der Freifläche verglichen und das Abbruchkriterium für den Lebensdauervergleich der beschichteten Wendeschneidplatten wurde bei 300 nm Verschleiß gewählt, falls es nicht schon vorher zum Versagen des Werkzeuges kam. Die Wendeschneidplatten wurden bei Schnittgeschwindigkeiten von v_{c} = 30, 60 und 90 m/min betrieben mit einem Vorschub von 0,2 mm/U und einer Schnitttiefe von 2 mm. Es wurde Kühlmittel verwendet. Die Ergebnisse zeigten die erwarteten 25 % Verbesserung der Lebensdauer der vom Hersteller beschichteten Version gegenüber der unbeschichteten für 30 m/min. Bei 60 m/min wurde die Schneidkante des unbeschichteten Werkzeuges instabil. Das Werkzeug mit der erfindungsgemäßen Schicht zeigte etwa 50 % höhere Lebensdauer gegenüber dem unbeschichteten Werkzeug bei 30 m/min und 20 % höhere Lebensdauer als das beschichtete Werkzeug bei 60 m/min. Es wurde auch bei 90 m/min ein deutlich qualitativer Unterschied beim Verschleiß gegenüber dem mit der vom Hersteller beschichteten Werkzeug festgestellt, der auf eine Stabilisierung der Schneidkante durch die erfindungsgemäße Schicht schließen lässt. In diesem Bereich versagte das unbeschichtete Werkzeug vollständig.

Die Anwendungsmöglichkeit dieser harten und hochtemperaturstabilen Schicht wurde auch noch für andere Anwendungen außerhalb der Werkzeugbeschichtung getestet. Vorteilhaft wirkte sich dabei aus, dass diese Oxidschichten eben auch bei tiefen Temperaturen hergestellt werden können, also auch normale Stähle und auch temperatursensitive Stähle mit dieser harten und oxidationsbeständigen Schicht versehen werden können. So wurden Komponenten und Bauteile im Motorenbereich beschichtet, die hohem Verschleiß bei hohen Temperaturen ausgesetzt sind, wie beispielsweise Kolbenoberflächen, Kolbenringe und Bauteile im Bereich des Turboladers und von anderen Teilen im Abgasbereich. Vorteilhaft ist auch der Schutz bei Heißgaskorrosionen im Turbinebereich des Flugzeugbaus.

Eine weitere Anwendung dieser Schicht wird für katalytische Anwendungen erwartet. Von Ni-Al-O Keramiken, die z.B. mit Sol-Gel-Technologie hergestellt werden können, weiß man, dass sie katalytische Wirkung haben, also z.B. Treibhausgase unschädlich. Daher wird typischerweise Nickel in eine Aluminiumoxidmatrix eingebettet, indem Nickel auf Aluminium aufgebracht wird und an Luft erhitzt wird. Es ist daher für einen Katalysator vorteilhaft, die erfindungsgemäße NiAl₂O₄ Schicht mit Aluminiumoxid zu verwenden, dessen Anteil eingestellt werden kann. Dies ist das erste Mal über eine Beschichtungsmethode möglich, die ohne Hochtemperaturschritt beide Materialien herstellen kann und zwar in einem Prozessschritt.

Vorteilhafte Wirkungen der Erfindung:
Zusätzlich zu den Schichtanteilen aus kubischem NiAl₂O₄ in Spinell-Struktur kann die Schicht weitere Anteile aus Aluminiumoxid besitzen, die zumindest aus einer der Hochtemperaturmodifikationen des Aluminiumoxids bestehen und zwar aus Aluminiumoxid der alpha-, gamma-, theta-, kappa-Struktur.

Die Schicht kann auch so synthetisiert werden, dass sie, neben dem kubischem NiAl₂O₄ in Spinell-Schichtanteil, Anteile von kubischem Ni-O in verschiedener Kristallitgröße enthält. Vorzugsweise kann die Schicht auch im Wesentlichen nur aus dem kubischem NiAl₂O₄ in Spinell-Anteil bestehen.

Die Schicht ist gekennzeichnet durch hochtemperaturstabile Eigenschaften, d.h. dass sie die für die Spinell typisch hohen Härten aufweist, die weniger schnell an Größe verlieren als das bei den Nitriden der Fall ist. Die kubische NiAl₂O₄ Spinell-Struktur der erfindungsgemäßen Schicht bleibt auch bei Temperaturen von über 1000°C erhalten.

Die kubische NiAl₂O₄ Schicht gewährleistet vor allem in Kombination mit kubischen Unterlagsschichten stabile Schichtübergänge, vor allem mit TiN, Ti-Al-N und TiCN, ZrN, Zr-Al-N, ZrCN, was zu hervorragender Schichthaftung beiträgt.

Neben der erfindungsgemäßen Schicht bestehend aus Ni-Al-O wurde noch ein weiteres neues Ni-Al-N Schichtsystem erstmals mit reaktiver Funkenbeschichtung synthetisiert, das nach dem gemessenem XRD-Spektrum kubische Struktur mit dem Spinell sehr ähnlichen Gitterkonstanten aufweist. Diese Tatsache erlaubt sowohl das "materialangepasste" wie "gitterkonstantenangepasste" Verbinden der Ni-Al-N und Ni-Al-O Schichten untereinander.

Besonders vorteilhaft gestaltet sich der Schichtverbund zwischen der Ni-Al-O Schicht mit materialfremden Schichten, falls diese ebenfalls kubische Struktur aufweisen mit Gitterkonstanten, die im Wesentlichen ein ganzzahliger Teil oder ein ganzzahliges Vielfaches der Gitterkonstante des Ni-Al-O Spinells sind, wie beispielsweise Al-Ti-N.

Die erfindungsgemäße Schicht aus Ni-Al-O weist eine hohe Härte auf, die über Hv 2300, vorzugsweise über Hv 2500, weiter vorzugsweise über Hv 2700 liegt. Die mechanische Festigkeit der Ni-Al-O Spinellschicht kann durch den Einbau von Aluminiumoxiden der Hochtemperaturstrukturen oder durch Ni-O weiter verbessert werden, insbesondere bezüglich Zähigkeit.

Dabei weist das neben dem NiAl₂O₄ in die Schicht eingebrachte zweite Oxid vorzugsweise stark unterschiedliche Kristallitgrößen auf, vorzugsweise kleinere als die des Spinell und weiter bevorzugt röntgenamorphe Struktur.

Als besonders chemisch stabil hat sich eine Schicht aus NiAl₂O₄ und NiO erwiesen, wobei beide Oxide in kubischer Struktur vorliegen.

Wie dargestellt kann der Übergang von Nitrid in das Oxid im gleichen Targetmaterial gefahren werden.

Es ist die Herstellung von Multilagenschichten von einem Targetmaterial durch Änderung des Sauerstoffflusses oder -druckes, was erstaunlicherweise zu einer Änderung im Ni/Al Verhältniss in der Multilagenstruktur führt.

Das Verfahren erlaubt die Herstellung einer Ni-Al enthaltenden Multilagenschicht in durchgehend kubischer Struktur durch Variation des Stickstoff-Sauerstoffflusses.

Das Verfahren gestattet die Herstellung von NiAl₂O₄ Schichten, insbesondere in Spinellstruktur, wobei über den Sauerstofffluss der Anteil an Aluminiumoxid und Nickeloxid gesteuert werden kann.

### Target

Mit dem Verfahren gelangt man, ausgehend von einem plasmagespritzten einphasigen Ni-Al Target zu einem Target, dessen Oberfläche mehrere intermetallische Verbindungen oder Mischkristalle der folgenden Art aufweist: Al₃Ni, Al₃Ni₂, AlNi, Al₃Ni₅, AlNi₃. Wichtig dabei ist, von welchem Konditionierungszustand des Targets ausgegangen wird. Insbesondere ist es möglich das Target hinter einem Shutter mittels verschiedener Sauerstoffflüssen zu konditionieren. Dies beispielsweise um Schichtinhomogenitäten zu vermeiden.

Die Erfindung lässt sich mit Vorteil unter anderem in folgenden Anwendungen einsetzen:
- Als Verschleißschutzschicht auf Schneidwerkzeugen, insbesondere besonders vorteilhaft auf WC und Cermets, Keramiken, Diamant und Substraten die Cr enthalten, wie beispielsweise HSS und auch für Anwendungen in schwer zerspanbarem Material.
- Zwischen Substrat und Funktionsschicht kann eine kubische CrN Schicht als Stützschicht vorgesehen werden.
- Als Hochtemperaturkorrosionsschutz sind die erfindungsgemäßen Schichten in Verbrennungsmotoren und Abgassystemen oder bei Turbinenschaufeln einsetzbar.

Es sei abschließend nochmals darauf hingewiesen dass die erfindungsgemäßen Schichten härter als Korund und zumindest in der Multischichtversion elastischer als gewöhnliche PVD-Oxide sind, dass eine Gitteranpassung möglich ist und beispielsweise die Einbettung einer kubischen NiAl₂O₄ Struktur in Hochtemperaturaluminiumoxidstrukturen vollzogen werden kann.

Es wurde eine Beschichtung vorgestellt, welche zumindest eine Verbindung von Sauerstoff und Stickstoff mit zumindest zwei metallischen Materialien umfasst, dadurch gekennzeichnet, dass die Verbindung zumindest teilweise in Spinellstruktur vorliegt.

Die Beschichtung kann eine intrinsische Druckspannung der die Verbindung aufweisenden Bestandteile zwischen 0,2 GPa und 5 GPa haben. Auf diese Weise wird die Stabilität der Beschichtung erhöht.

Vorzugsweise ist eines der mindestens zwei metallischen Materialien Nickel und/oder Aluminium. Im Falle von Nickel und Aluminium zeigt das XRD-Spektrum möglicherweise die 311, 400 Reflexe und vorzugsweise auch den 511 Reflex.

Die Verbindung kann NiAl₂O₃ sein und weitere Bestandteile der Beschichtung können in röntgenamorpher Phase vorliegen. Gegebenenfalls können die in röntgenamorpher Phase vorliegenden weiteren Bestandteile Aluminiumoxid und/oder Nickeloxid umfassen, wobei gegebenenfalls das Aluminiumoxid vorzugsweise in Korundstruktur und/oder gamma Phase vorliegt.

Eine solche Beschichtung kann eine Vielzahl von aufeinander liegenden Schichten umfassen und die Schichten können im Wesentlichen identische metallische chemische Elemente jedoch mit unterschiedlichen metallischen Anteilen aufweisen. Insbesondere können die Schichten sogar im Wesentlichen identische chemische Elemente aufweisen.

Die Beschichtung kann die für das Funkenverdampfen typischen Droplets aufweisen.

Es kann eine kubische Stützschicht umfasst sein, vorzugsweise aus der Gruppe Al-Ti-N, Ti-C-N, Ti-N, Cr-N oder deren Mischungen.

Es wurde ein Verfahren zur Beschichtung von Substraten mittels Funkenverdampfen offenbart, das dadurch gekennzeichnet ist, dass als Target ein Legierungstarget verwendet wird, welches zwischen 10 at% und 80 at%, vorzugsweise zwischen 20 at% und 60 at% Nickel aufweist und dass als Reaktivgas Sauerstoff und/oder Stickstoff verwendet wird. Das Legierungstarget kann Aluminium aufweisen.

Mittels des Sauerstoffflusses, vorzugsweise zwischen 300 sccm und 800 sccm, kann erfindungsgemäß das Al/Ni-Verhältnis während der Beschichtung variiert werden.

Es wurden beschichtete Substrate, insbesondere Werkzeuge oder Komponenten offenbart, die dadurch gekennzeichnet sind, dass die Oberfläche des Substrates, auf die die Beschichtung zu liegen kommt, ein Stahl, insbesondere Cr enthaltender Stahl, wie zum Beispiel HSS umfasst. Das beschichtete Substrat kann eine Wendeschneidplatte sein.

## Patentansprüche

1. Beschichtung, welche zumindest eine Verbindung von Sauerstoff und Stickstoff mit zumindest zwei metallischen Materialien umfasst, **dadurch gekennzeichnet, dass** die Verbindung zumindest teilweise in Spinellstruktur vorliegt und die zumindest zwei metallischen Materialien Nickel umfassen.

2. Beschichtung nach Anspruch 1, **dadurch gekennzeichnet, dass** die intrinsische Druckspannung der die Verbindung aufweisenden Bestandteile der Beschichtung zwischen 0,2 GPa und 5 GPa beträgt.

3. Beschichtung nach einem der Ansprüche 1 und 2, **dadurch gekennzeichnet, dass** die zumindest zwei metallischen Materialien Aluminium umfassen.

4. Beschichtung nach Anspruch 1, **dadurch gekennzeichnet, dass** das XRD-Spektrum die 311 und 400 Reflexe zeigt.

5. Beschichtung nach Anspruch 4, **dadurch gekennzeichnet, dass** das XRD-Spektrum den 511 Reflex zeigt.

6. Beschichtung nach einem der vorangehenden Ansprüche, **dadurch gekennzeichnet, dass** die Beschichtung aus einer Vielzahl von aufeinander liegenden Schichten ausgebildet ist, wobei die Schichten identische metallische chemische Elemente jedoch mit unterschiedlichen metallischen Anteilen aufweisen.

7. Beschichtung nach einem der vorangehenden Ansprüche, **dadurch gekennzeichnet, dass** die Beschichtung die für das Funkenverdampfen typischen Droplets aufweist.

8. Beschichtung nach einem der vorangehenden Ansprüche, **dadurch gekennzeichnet, dass** diese eine kubische Stützschicht umfasst, vorzugsweise aus der Gruppe Al-Ti-N, Ti-C-N, Ti-N, Cr-N oder deren Mischungen.

9. Beschichtetes Substrat, **dadurch gekennzeichnet, dass** die Oberfläche des Substrates, auf die die Beschichtung zu liegen kommt, einen Cr enthaltenden Stahl mit einer Beschichtung gemäß einem der Ansprüche 1 bis 8 umfasst.

10. Beschichtetes Substrat, **dadurch gekennzeichnet, dass** es sich um eine Wendeschneidplatte handelt, wobei eine Beschichtung gemäß Anspruch 8 vorgesehen ist.

## Claims

1. Coating, which comprises at least one compound of oxygen and nitrogen with at least two metallic materials, **characterized in that** the compound is present at least partly in spinal structure and that the at least two metallic materials comprise nickel.

2. Coating according to claim 1, **characterized in that** the intrinsic compression stress of the components of the coating comprising the compound amounts to between 0.2 GPa and 5 GPa.

3. Coating according to one of claims 1 and 2, **characterized in that** the at least two metallic materials comprise aluminum.

4. Coating according to claim 1, **characterized in that** the XRD pattern displays the reflections 311 and 400.

5. Coating according to claim 4, **characterized in that** the XRD pattern displays reflection 511.

6. Coating according to one of the preceding claims, **characterized in that** the coating is made of a multitude of layers lying one above the other, wherein the layers comprise identical metallic chemical elements, but with different metallic proportions.

7. Coating according to one of the preceding claims, **characterized in that** the coating has the droplets typical for arc evaporation.

8. Coating according to one of the preceding claims, **characterized in that** it comprises a cubic support layer, preferably from the group Al-Ti-N, Ti-C-N, Cr-N or their mixtures.

9. Coated support, **characterized in that** the surface of the support on which the coating is going to lie comprises a Cr containing steel with a coating according to one of claims 1 to 8.

10. Coated support, **characterized in that** it is an indexable insert, wherein a coating according to claim 8 is provided.

## Revendications

1. Revêtement, lequel compprend au moins un composé d'oxygène et de nitrogène avec au moins deux matériaux métalliques, **caractérisé en ce que** le composé est présent au moins en partie en structure de spinelle et que les au moins deux matériaux métalliques comprennent du nickel.

2. Revêtement selon la revendication 1, **caractérisé en ce que** la tension de pression intrinsèque des composants du revêtement comprenant le composé comporte entre 0,2 GPa et 5 GPa.

3. Revêtement selon une des revendications 1 ou 2, **caractérisé en ce que** les au moins deux matériaux métalliques comprennent de l'aluminium.

4. Revêtement selon la revendication 1, **caractérisé en ce que** le spectre de diffraction de rayons X (XRD) présente les réflexions 311 et 400.

5. Revêtement selon la revendication 4, **caractérisé en ce que** le spectre de diffraction de rayons X (XRD) présente la réflexion 511.

6. Revêtement selon l'une des revendications précédentes, **caractérisé en ce que** le revêtement est formé d'une multitude de couches couchées les unes au-dessus des autres, dans lequel les couches comprennent des éléments chimiques métalliques identiques, mais en différentes proportions métalliques.

7. Revêtement selon l'une des revendications précédentes, **caractérisé en ce que** le revêtement présente les gouttelettes typiques pour l'évaporation à arc.

8. Revêtement selon l'une des revendications précédentes, **caractérisé en ce que** celui-ci comprend une couche d'appui cubique, préférablement du groupe Al-Ti-N, Ti-C-N, Ti-N, Cr-N ou leurs mélanges.

9. Support revêtu, **caractérisé en ce que** la surface du support, sur laquelle le revêtement sera couché, comprend un acier comprenant du Cr avec un revêtement selon l'une des revendications 1 à 8.

10. Support revêtu, **caractérisé en ce qu'**il s'agit d'une plaquette de coupe réversible, dans lequel un revêtement selon la revendication 8 est pourvu.
